(19) Europäisches Patentamt

European Patent Office

Office européen des brevets

(11) **EP 0 840 206 B1**

(12) **EUROPÄISCHE PATENTSCHRIFT**

(45) Veröffentlichungstag und Bekanntmachung des Hinweises auf die Patenterteilung:
**13.04.2005 Patentblatt 2005/15**

(51) Int Cl.$^7$: **G06F 7/52**

(21) Anmeldenummer: **97116736.6**

(22) Anmeldetag: **25.09.1997**

(54) **Schwellwertlogik-Schaltungen mit geringem Flächenbedarf**

Threshold logic circuits with limited area

Circuit à logique de seuil avec surface réduite

(84) Benannte Vertragsstaaten:
**DE FR GB IE IT**

(30) Priorität: **29.10.1996 DE 19644976**

(43) Veröffentlichungstag der Anmeldung:
**06.05.1998 Patentblatt 1998/19**

(73) Patentinhaber: **Infineon Technologies AG**
**81669 München (DE)**

(72) Erfinder:
• **Luck, Andreas**
 **81737 München (DE)**
• **Thewes, Roland, Dr.**
 **82194 Gröbenzell (DE)**

• **Weber, Werner, Dr.**
 **80637 München (DE)**

(74) Vertreter: **Epping Hermann & Fischer**
 **Ridlerstrasse 55**
 **80339 München (DE)**

(56) Entgegenhaltungen:
 DE-A- 19 521 089    DE-A- 19 521 092
 US-A- 4 663 740

• **PELAYO F ET AL: "SOME IMPROVEMENTS IN THE IMPLEMENTATION OF MULTITHRESHOLD AND MULTIVALUED I2L CIRCUITS" INTERNATIONAL JOURNAL OF ELECTRONICS, Bd. 66, Nr. 1, Seiten 19-34, XP000111343**

# EP 0 840 206 B1

## Beschreibung

Eine Schwellwertlogikschaltung enthält im wesentlichen Elemente zur Summenbildung gewichteter Eingangsgrößen und anschließender Schwellwertbildung. Für derartige Logikschaltungen können unter anderem sogenannte Neuron-MOS-Transistoren, die ein Floating Gate ähnlich wie bei EPROMs aufweisen, Verwendung finden.

Aus IEEE Transactions on Electron Devices, Vol. 39, No. 6, June 1992, pp. 1444-1455, ist der Aufbau von Neuron-MOS-Transistoren und ihre Verwendung in Schwellwertlogik-Schaltungen bekannt.

Aus der internationalen Anmeldung WO 96/42 049 A1 mit Veröffentlichungsdatum 27. Dezember 1996 ist eine Schwellwertlogik-Schaltung bekannt, bei der mindestens ein erster und zweiter Schaltungsteil mit jeweils einer Bewerterschaltung und Elementen zur Summenbildung gewickelter Eingangsgrößen vorhanden sind.

In dem Dokument DE 19521089 C1 ist eine Schaltungsordnung zur Realisierung von durch Schwellenwertgleichungen darstellbaren Logikelementen angegeben. Dabei werden die durch parallel geschaltete Transistoren fließenden Ströme summiert und von einer Bewertungseinheit mit einem Referenzstrom verglichen.

Die der Erfindung zugrundeliegende Aufgabe besteht nun darin, eine Schwellwertlogikschaltung anzugeben, die eine möglichst geringe Chipfläche aufweist. Diese Aufgabe wird erfindungsgemäß durch die Merkmale des Anspruchs 1 gelöst. Die Unteransprüche betreffen vorteilhafte Ausgestaltungen der Erfindung.

Die Erfindung wird im folgenden anhand der Zeichnung näher erläutert. Dabei zeigt

Figur 1   ein Schaltbild einer erfindungsgemäßen Schwellwert logik-Schaltung am Beispiel eines Multiplizierers und

Figur 2   ein Schnittbild eines Teiles der erfindungsgemäßen Schwellwertlogik-Schaltung nach Figur 1.

Viele logische Operationen, wie z. B. die binäre Multiplikation oder die binäre Addition, können in Form eines Systems von Schwellwertgleichungen wie folgt beschrieben werden:

$$
\begin{aligned}
f_1(x_1, \ldots, x_m) &= 1, \text{ wenn } w_{11}x_1 + w_{12}x_2 + \ldots + w_{1m}x_m \geq T_1 \\
&= 0, \text{ sonst} \\
&\vdots \\
f_n(x_1, \ldots, x_m) &= 1, \text{ wenn } w_{n1}x_1 + w_{n2}x_2 + \ldots + w_{nm}x_m \geq T_n \\
&= 0, \text{ sonst}
\end{aligned}
\tag{1}
$$

$$\text{mit } n \geq 2 \text{ und } m \geq 2.$$

Dabei stellen xi mit i = 1 ... m die Eingangsgrößen, $w_{ki}$ mit i = 1 ... m und k = 1 ... n die Gewichtungsfaktoren und $T_i$ mit i = 1 ... n die Schwellwerte des Gleichungs- bzw. Ungleichungssystems dar. In schaltungstechnischen Realisierungen sind die $x_i$ häufig binäre Größen, die nur die Werte 0 und 1 annehmen können. Sofern mindestens zwei Vektoren $(w_{i1}, w_{i2}, \ldots, w_{im})$ und $(w_{j1}, w_{j2}, \ldots, w_{jm})$ der Gewichtungsfaktoren einer Zeile mit i ≠ j, i ≤ n und j ≤ n in der Art ähnlich sind, daß viele Elemente übereinstimmen, d. h. daß $w_{ik} = w_{jk}$ für möglichst viele Indizes k mit 1 ≤ k ≤ m gilt, lassen sich die Bedingungsseiten der Zeilen i und j des Gleichungssystem (1) derart umformen, daß auf der einen Seite, im folgenden auf der linken Seite, des "≥"-Zeichens gleiche Teilsummen stehen, während auf der anderen Seite, im folgenden auf der rechten Seite, die Terme stehen, welche bei beiden Zeilen nicht übereinstimmen. In formaler Schreibweise ergibt sich also für die Zeilen i und j

$$f_i(x_1, \ldots, x_m) = 1, \text{ wenn } \sum_{\substack{\text{über alle } t \text{ für} \\ \text{die } w_{it}=w_{jt} \text{ gilt.}}} w_{it}x_t \geq T_i + \sum_{\substack{\text{über alle } t \text{ für} \\ \text{die } w_{it} \neq w_{jt} \text{ gilt.}}} w_{it}x_t \,,$$

$$f_i = 0, \text{ sonst} \tag{2}$$

$$f_j(x_1, \ldots, x_m) = 1, \text{ wenn } \sum_{\substack{\text{über alle } t \text{ für} \\ \text{die } w_{it}=w_{jt} \text{ gilt.}}} w_{jt}x_t \geq T_j + \sum_{\substack{\text{über alle } t \text{ für} \\ \text{die } w_{it} \neq w_{jt} \text{ gilt.}}} w_{jt}x_t \,,$$

$$f_j = 0, \text{ sonst}$$

Sofern auch noch $T_i = T_j$ gilt, wird auch $T_i$ bzw. $T_j$ auf die Seite mit identischen Teilsummen gebracht.

Für eine schaltungstechnischen Umsetzung folgt aus dem System (2) nun, daß der gemeinsame Teilsummenterm, hier jeweils die linke Seite in den Ungleichungen, nur einmal realisiert wird, wobei dann dieses in einer Teilschaltung einmalig realisierte Teilsummensignal auch anderen Teilen der Schwellwertlogik-Schaltung zur Verarbeitung zugeführt wird.

Wie bereits oben erwähnt, lautet die Mindestbedingung, daß mindestens zwei Funktionen $f_i$ und $f_j$ des Gleichungssystems (1) gleiche Teilsummenterme im Bedingungsteil aufweisen. Sind in einem Gleichungssystem mehrere Funktionen mit identischen Teilsummen vorhanden, so können diese zu entsprechenden Gruppen zusammengefaßt werden, wobei für jede Funktionsgruppe der jeweils identische Term im Minimalfall nur ein einziges Mal erzeugt wird.

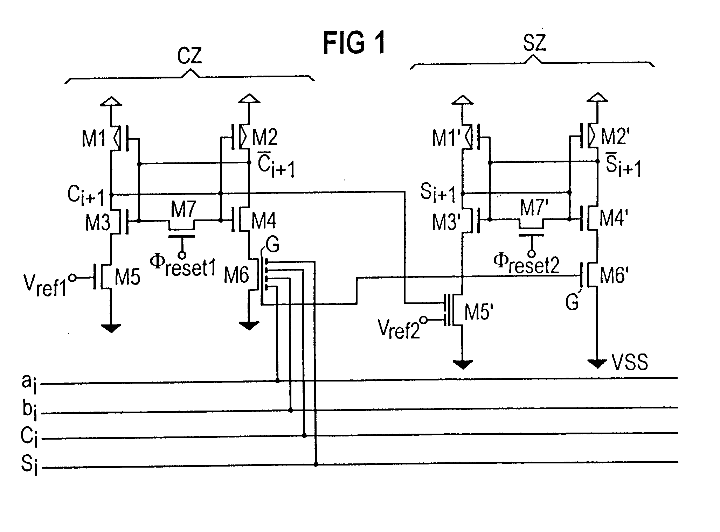

In Figur 1 ist beispielhaft eine erfindungsgemäße Multipliziererzelle als Schwellwertlogik-Schaltung mit den folgenden Gleichungen

$$C_{i+1}(a_1,a_2,S_i,C_i) = 1, \text{ wenn } a_1+a_2+2{*}S_i+2{*}C_i-4 \geq 0$$

$$=0, \text{ sonst} \tag{3}$$

und

$$S_{i+1}(a_1,a_2,S_i,C_i,C_{i+1}) = 1, \text{ wenn } a_1+a_2+2{*}S_i+2{*}C_i-4{*}C_{i+1}-2 \geq 0$$

$$=0, \text{ sonst} \tag{4}$$

dargestellt, wobei $a_i$ und $b_i$ zu multiplizierenden Bits, $C_i$ und $S_i$ ein Carrybit und Summenbit einer unmittelbar vorhergehenden Stufe sowie $C_{i+1}$ und $S_{i+1}$ ein Carrybit und Summenbit für eine unmittelbar folgende Stufe darstellen und wobei die Multipliziererzelle einen Zellenteil CZ zur Bildung des Carrybits $C_{i+1}$ und einen Zellenteil SZ zur Bildung des Summenbits $S_{i+1}$ aufweist.

Der Zellenteil CZ beinhaltet eine Bewerterschaltung, die zwei Eingangszweige zur gewichteten Summation von Eingangs- und Referenzsignalen aufweist. Die Bewerterschaltung weist p-Kanal-MOS-Transistoren M1 und M2 sowie n-Kanal-MOS-Transistoren M3, M4 und M7 auf, wobei die Transistoren M1 und M3 sowie die Transistoren M2 und M4 jeweils Inverter bilden, die kreuzweise rückgekoppelt sind und somit miteinander ein Halteglied bilden, das durch einen die Eingänge dieser Inverter verbindenden Transistor M7 mit Hilfe eines Rücksetzsignales $\Phi_{reset1}$ rückgesetzt werden kann. Der Inverter aus den Transistoren M1 und M3 bildet das Übertragssignal $C_{i+1}$ und ist über den linken Zweig in Form eines n-Kanal-MOS-Transistors M5 mit Bezugspotential VSS verbunden, wobei am Gate des Transistors M5 eine Referenzspannung Vref zur Einstellung der Schwelle gemäß Gleichung (3) anliegt. Der Inverter aus den Transistoren M2 und M4 ist über den rechten Zweig in Form eines Neuron-MOS-Transistors M6 mit Bezugspotential VSS verbunden, wobei ein Floating Gate G des Transistors M6 ein Teilsummensignal TS = $a_1$ +$a_2$ +2*$S_i$ +2*$C_i$ führt und die davon isolierten Eingangs-Gates mit den Eingängen für die Bits $a_i$, $b_i$, $C_i$ und $S_i$ beschaltet sind.

Der Zellenteil SZ zur Bildung des Summenbits $S_{i+1}$ beinhaltet, wie der Zellenteil CZ zur Bildung des Carrybits $C_{i+1}$, ebenfalls eine Bewerterschaltung mit zwei Eingangszweigen, wobei die Bewerterschaltung Transistoren M1', M2', M3', M4' und M7' aufweist und an Stelle des Signals $C_{i+1}$ das Signal $S_{i+1}$ bildet. Der linke Zweig im Zellenteil SZ weist einen Neuron-MOS-Transistor M5' zur Bildung des Wertes 4*$C_{i+1}$+2, wobei sich dieser Term durch eine Umformung von Gleichung (4) ergibt. Der rechte Zweig des Zellenteils SZ wird durch das Floating Gate G des n-Kanal-MOS-Transitors M6 mit dem Teilsummensignal TS = $a_1$ +$a_2$ +2*$S_i$ +2*$C_i$ versorgt.

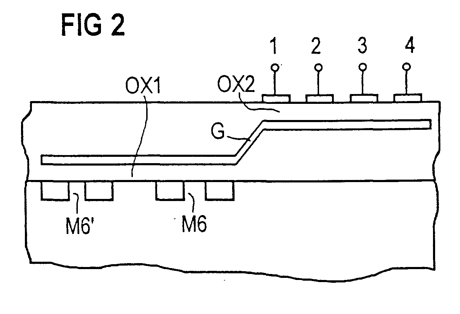

Dies geschieht vorteilhafterweise dadurch, daß, wie in Figur 2 beispielshaft gezeigt, die Kanalbereiche der entsprechenden Neuron-MOS-Transistoren M6 und M6' relativ dicht beieinander liegen und von einem durch eine dünne Isolatorschicht OX1 isolierten gemeinsamen elektrisch leitenden Gebiet für das Floating Gate G überdeckt sind. Die Eingangsgates 1...4 des Transistors M6 sind durch eine dünne Isolatorschicht OX2 vom Floating Gate G getrennt und bilden so einseitig miteinander verbunden Eingangskapazitäten zur Erzeugung des Teilsummensignals TS auf dem Floatig Gaate G. Die Isolatorschichten OX1, OX2 bestehen hierbei beispielsweise aus $SiO_2$ und das elektrisch leitenden Gebiet beisielsweise aus Polysilizium.

Ensprechendes gilt für jede Schwellwertlogik-Schaltung mit einem ersten Schaltungsteil CZ und mindestens einem zweiten Schaltungsteil SZ, deren Schwellenwertgleichungen so umgeformt werden können, daß sie identische Teilsummensignale TS aufweisen, wobei ein in dem ersten Schaltungsteil CZ gebildetes Teilsummensignal TS dem zweiten Schaltungsteil SZ zugeführt ist, damit in dem mindestens zweiten Schaltungsteil das Teilsummensignal nicht mehr mit Hilfe eines relativ großflächigen Neuron -MOS-Transistors mit vielen Eingangsgates erneut gebildet werden muß.

**Patentansprüche**

1.  Schwellwertlogik-Schaltung mit einem ersten und mindestens einem zweiten Schaltungsteil (CZ, SZ), die jeweils eine Bewerterschaltung (M1,M2,M3,M4,M7; M1',M2',M3',M4',M7') sowie Neuron-MOS-Transistoren (M5, M5',M6, M6') aufweisen,

    -   bei der in dem ersten Schaltungsteil (CZ) ein gemeinsames Teilsummensignal (TS) einer ersten und mindestens einer zweiten Schwellwertgleichung auf einer Floating Gateelektrode eines Neuron-MOS-Transistors (M6) gebildet ist und
    -   bei der in dem mindestens zweiten Schaltungsteil (SZ) mindestens ein weiterer Neuron-MOS-Transistor (M6') durch das gemeinsame Teilsummensignal (TS) des ersten Schaltungsteils (CZ) ansteuerbar ist.

2.  Schwellwertlogik-Schaltung nach Anspruch 1,

    -   bei der das gemeinsame Teilsummensignal (TS) über ein gemeinsames Polysiliziumgebiet gleichzeitig die Kanäle von mindestens zwei Neuron MOS-Transistoren (M6, M6') in mindestens zwei Schaltungsteilen (CZ, SZ) ansteuert.

3.  Schwellwertlogik-Schaltung nach Anspruch 1 oder 2,

    -   bei der zur Bildung eines Multiplikationsübertragbits ($C_{i+1}$) auf einer von Eingangssignalen ($a_i$, $b_i$, $C_i$, $S_i$) für Multiplikationsbits, Übertragseingangsbit und Summeneingangsbit elektrisch isolierten Floating Gateelektrode (G) des Neuron-MOS-Transistors (M6) im ersten Schaltungsteil (C2) ein Teilsummensignal (TS) gebildet ist, das zur Bildung eines Multiplikationssummenbits ($S_{i+1}$) in dem zweiten Schaltungsteil (SZ) einen weiteren Neuron-MOS-Transitor (M6') ansteuert.

**Claims**

1.  Threshold value logic circuit having a first and at least a second circuit part (CZ, SZ) which each have a weighting circuit (M1, M2, M3, M4, M7; M1', M2', M3', M4', M7') as well as neuron MOS transistors (M5, M5', M6, M6'),

    -   in which, in the first circuit part (CZ), a common partial sum signal (TS) of a first and of at least one second threshold value equation is formed at a floating gate electrode of a neuron MOS transistor (M6), and

- in which, in the at least second circuit part (SZ), at least a further neuron MOS transistor (M6') can be driven by the common partial sum signal (TS) from the first circuit part (CZ).

2. Threshold value logic circuit according to Claim 1,

- in which the common partial sum signal (TS) simultan-eously drives, via a common polysilicon region, the channels of at least two neuron MOS transistors (M6, M6') in at least two circuit parts (CZ, SZ).

3. Threshold value logic circuit according to Claim 1 or 2,

- in which a partial sum signal (TS) is formed, in order to form a multiplication carry bit ($C_{i+1}$), on a gate electrode (G) of the neuron MOS transistor (M6) in the first circuit part (C2), this floating gate electrode (G) being electrically insulated from input signals ($a_i$, $b_i$, $C_i$, $S_i$) for multiplication bits, a carry input bit and a sum input bit, and the partial sum signal (TS) drives a further neuron MOS transistor (M6') in order to form a multiplication sum bit ($S_{i+1}$) in the second circuit part (SZ).

**Revendications**

1. Circuit à logique de seuil, comprenant une première et au moins une deuxième partie (CZ, SZ) de circuit qui ont respectivement un circuit (M1, M2, M3, M4, M7 , M1', M2', M3', M4', M7') d'évaluation ainsi que des transistors (M5, M5', M6, M6') Neuron-MOS,

- dans lequel il est formé dans la première partie (CZ) de circuit un sous-signal (TS) commun de somme d'une première et d'au moins une deuxième équations de valeur de seuil sur une électrode de grille flottante d'un transistor (M6) Neuron-MOS et
- dans lequel dans la au moins deuxième partie (SZ) de circuit au moins un autre transistor (M6') Neuron-MOS peut être commandé par le sous-signal (TS) commun de somme de la première partie (CZ) de circuit.

2. Circuit à logique de seuil suivant la revendication 1,

- dans lequel le sous-signal (TS) commun de somme commande par une zone commune de polysilicium en même temps les canaux d'au moins deux transistors (M6, M6') Neuron-MOS dans au moins deux parties (CZ, SZ) de circuit.

3. Circuit à logique de seuil suivant la revendication 1 ou 2,

- dans lequel, pour la formation d'un bit ($C_{i+1}$) de report de multiplication , il est formé, sur une électrode (G) de grille flottante du transistor (M6) Neuron-MOS de la première partie (C2) de circuit, électrode isolée électriquement de signaux ($a_i$, $b_i$, $C_i$, $S_i$) d'entrée de bits de multiplication, d'un bit d'entrée de report et d'un bit d'entrée de somme, un sous-signal (TS) de somme, qui, pour la formation d'un bit ($S_{i+1}$) de sommes de multiplication dans la deuxième partie (SZ) de circuit, commande un autre transistor (M6') Neuron-MOS.

**FIG 1**

EP 0 840 206 B1

FIG 2